# EUROPEAN PATENT APPLICATION

(11) **EP 1 553 635 A1**
(43) Date of publication of application: **13.07.2005**
(21) Application number: 04250071.0
(22) Date of filing: 08.01.2004
(51) Int. Cl.: H01L 29/792

(54) **Nonvolatile semiconductor memory and operating method of the memory**

(71) Applicant: Macronix International Co., Ltd., Hsinchu 300 (TW)
(72) Inventor: Yeh, Chih Chieh, Taipei, Taiwan (CN); Tsai, Wen Jer, Hualien, Taiwan (CN); Lu, Tao Cheng, Kaohsiung, Taiwan (CN)
(74) Representative: Beck, Simon Antony

(57) **Abstract**

A nonvolatile memory comprises a memory cell and a memory control circuit coupled with the memory cell. The memory cell is formed on a semiconductor substrate and includes a source, a drain, and a channel region, a first isolating layer overlying the channel region, a nonconducting charge trapping layer overlaying the first isolating layer, a second isolating layer overlaying the nonconducting charge trapping layer, and a gate overlaying the second isolating layer. The memory control circuit is configured to erase the memory cell by injecting electrons in the nonconducting trapping layer.

## Description

### Field of the Invention

The invention generally relates to semiconductor memory devices and more particularly to a nonvolatile semiconductor memory cell storing electrons in an erase state, and its operating method.

### Description of the Related Art

Memory devices for nonvolatile storage of information are in widespread use in the art. Exemplary nonvolatile semiconductor memory devices include read only memory (ROM), programmable read only memory (PROM), erasable programmable read only memory (EPROM), electrically erasable programmable read only memory (EEPROM) and flash EEPROM.

Flash EEPROMs are similar to EEPROMs in that memory cells can be programmed (i.e., written) and erased electrically but with the additional capability of erasing all memory cells at once. The widespread use of EEPROM semiconductor memory has prompted much research focusing on developing an EEPROM memory cell with optimal performance characteristics such as shorter programming times, lower voltage usage for programming and reading, longer data retention time, shorter erase time and smaller physical dimensions.

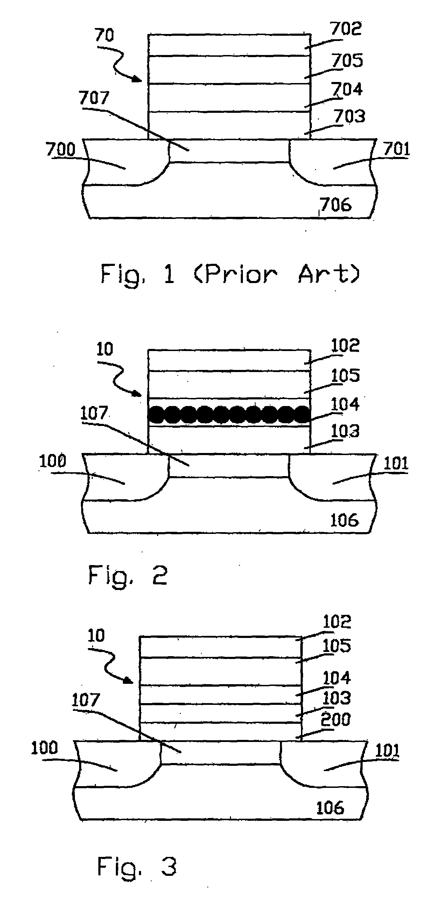

Fig. 1 is a block diagram that illustrates the structure of a prior art nonvolatile memory cell where a nonvolatile memory cell 70 includes an N-channel MOSFET structure. The nonvolatile memory cell 70 includes a P type substrate 706 with two buried N+ junctions, one being the source 700 and the other being the drain 701. A channel 707 is formed between the source 700 and the drain 701. Above the channel is a first isolating layer 703, which generally is a silicon oxide layer. On top of the first isolating layer 703 is a trapping layer 704, which generally is a nitride layer. The trapping layer 704 forms the memory retention layer that traps the hot electrons as they are injected into the nitride layer. A second isolating layer 705, which generally is an oxide layer, is formed to overlay the silicon nitride layer. The silicon oxide layer 705 electrically isolates a conductive gate 702 formed over the second isolating layer 705. The two silicon oxide layers 703 and 705 function as isolation dielectric layers.

This prior art structure can provide a two-bit cell, i.e., the nonvolatile memory cell can store two bits of data. The memory is programmed by channel hot electron injection. By applying programming voltages to the gate 702 and the drain 701 while the source 700 is grounded, electrons can be accelerated sufficiently to be injected into the trapping layer 704 near the drain side 701 so as to increase the energy barrier in the channel 707 near the drain side 701 where a bit of data is stored therein. In addition, electrons can be injected into the trapping layer 704 near the source side 702 to increase the energy barrier in the channel 707 near the source side 701 where another bit of data is stored therein. Provided that the trapping layer 704 includes an appropriate width, the two areas storing electrons in the trapping layer 704 can be identified and used for storing two bits of data.

Regarding the energy barrier of the prior art nonvolatile memory cell, the trapping layer is in a neutral state. When no charge is stored in the trapping layer, the energy barrier in the channel 707 is at a low state. In programming the nonvolatile memory cell, the electrons are injected into the trapping layer near, e.g., the drain 701, so that the energy barrier in the channel 707 near the drain 701 is increased. Moreover, when the electrons are injected into the trapping layer 704 near the source 700, the energy barrier in the channel 707 near the source 700 is increased. The energy barrier in the channel 707 thus includes two high-level sections distributed at two sides of the energy barrier. The threshold voltage of a cell is defined as the gate voltage that is sufficient to invert the channel and cause the current between source and drain. Generally speaking, higher energy barrier in the channel would have a higher threshold voltage while lower energy barrier would have a lower threshold voltage.

Conventional programming using hot electron injection requires high operating voltages and consumes high power. As the size of the nonvolatile cell is reduced and the channel is relatively small, the high operating voltage induces a punch-through effect resulting in high leakage current and low program efficiency. Such becomes a significant design and implementation shortcoming in prior art nonvolatile memory devices serving as two-bit memory cells. Further, the prior art structure requires a particularly confined size, which impedes engineering efforts on size and cost reduction therefor.

Thus, there is a general need in the art for a nonvolatile memory device with an optimal two-bit cell structure, and more particularly, a nonvolatile memory device and associated methods therefor that overcome at least the aforementioned disadvantages of nonvolatile memory devices in the art. In particular, there is a need in the art for a nonvolatile memory device with amplified effects for the trapped electron charges in the trapping dielectric layer and an optimally reduced size.

### SUMMARY OF THE INVENTION

The application describes a nonvolatile memory. In one embodiment, the nonvolatile memory comprises a memory cell and a memory control circuit coupled with the memory cell. The memory cell comprises a semiconductor substrate in which are formed a source, a drain spaced from the source, and a channel between the source and the drain, a first isolating layer overlying the channel, a nonconducting charge trapping layer on the first isolating layer, a second isolating layer on the nonconducting charge trapping layer, and a gate on the second isolating layer.

In one embodiment, the memory control circuit is configured to apply voltage biases to the memory cell so as to inject electrons in the nonconducting charge trapping layer in an erase state. The memory control circuit is further configured to program the memory cell by applying voltage biases to inject electric holes in the nonconducting charge trapping layer. In a variant embodiment, a tunneling layer is added between the channel and the first isolating layer so as to reduce the injecting energy barrier from the channel to the nonconducting charge trapping layer, so that the electrons and holes are readily injected into the trapping layer in the operation mode.

The foregoing is a summary and shall not be construed to limit the scope of the claims. The operations and structures disclosed herein may be implemented in a number of ways, and such changes and modifications may be made without departing from this invention and its broader aspects. Other aspects, inventive features, and advantages of the invention, as defined solely by the claims, are described in the non-limiting detailed description set forth below.

### BRIEF DESCRIPTION OF THE DRAWINGS

Fig. 1 is schematic view illustrating a nonvolatile memory cell in the prior art;

Fig. 2 is a schematic view illustrating a preferred embodiment of the nonvolatile memory cell of the invention;

Fig. 3 is a schematic view illustrating a further embodiment of the nonvolatile memory cell of the invention with a tunneling layer;

Figs. 4A and 4B are a schematic views respectively illustrating an exemplary operation of programming the source bit and drain bit of the nonvolatile memory cell according to an embodiment of the invention;

Figs. 5A and 5B are schematic views respectively illustrating an exemplary operation of reading the source bit and drain bit of the nonvolatile memory cell according to another embodiment of the invention;

Fig. 6A illustrates an exemplary energy barrier distribution and voltage distribution for reading one bit near the source as the bit is at low state with the bit near the drain in low and high states;

Fig. 6B illustrates an exemplary energy barrier distribution and voltage distribution for reading one bit near the source as the bit is at a high state with the bit near the drain in low and high states;

Fig. 6C illustrates an exemplary energy barrier distribution and voltage distribution for reading one bit near the drain as the bit is at low state with the bit near the drain in low and high states;

Fig. 6D illustrates an exemplary energy barrier distribution and voltage distribution for reading one bit near the drain as the bit is at a high state with the bit near the drain in low and high states;

Fig. 7 illustrates an exemplary erase operation according to the invention where electrons are injected into the trapping layer from the semiconductor substrate;

Fig. 8 illustrates another exemplary erase operation according the invention where electrons are injected into the trapping layer from the gate;

Fig. 9 illustrates an exemplary erase operation for the flash memory cell according the invention using hot electron injection from the drain by applying serial voltage pulses to the substrate;

Fig. 10 illustrates another exemplary erase operation of the flash memory cell according to the invention using hot electron injection from the source and drain by applying serial voltage pulses to the substrate;

Fig. 11 illustrates yet another exemplary erase operation of the flash memory cell according to the invention using hot electron injection by applying serial voltage pulses to the semiconductor substrate;

Fig. 12 illustrates a further exemplary erase operation of the nonvolatile memory cell according to the invention using electron injection using electron injection with hot electrons emitted from the N well;

Fig. 13 illustrates an additional exemplary erase operation of the nonvolatile memory cell according to the invention using electron injection using electron injection with hot electrons emitted from the N injector; and

Fig. 14 is a block diagram of a nonvolatile memory according to an embodiment of the invention.

### DETAILED DESCRIPTION OF THE EMBODIMENT(S)

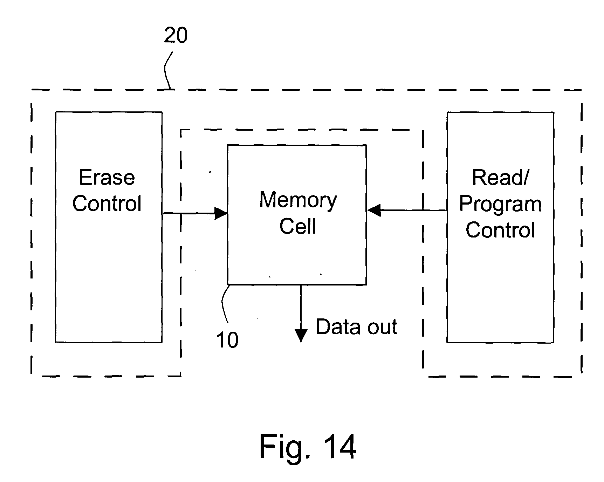

Referring to Fig. 14, a block diagram schematically illustrates a nonvolatile memory according to an embodiment of the invention. The nonvolatile memory comprises one or more memory cell 10 and a memory control circuit 20. The memory control circuit 20 is coupled with the memory cell 10, and is configured to control the operation of the memory cell 10, including erase, program and read operations.

Fig. 2 is a schematic view of a nonvolatile memory cell 10 implemented according to an embodiment of the invention. The nonvolatile memory cell 10 has an N-channel MOSFET structure. In the nonvolatile memory cell 10, a P-type substrate 106 includes two buried N+ junctions, one being the source 100 and the other being the drain 101. A channel 107 is formed between the source 100 and the drain 101. Above the channel is formed a first isolating layer 103, which is a silicon oxide layer. On top of the first isolating layer 103 is a trapping layer 104. The trapping layer 104 is made of a nonconducting material, which can be nitride, Al₂O₃ or HFO₂. The trapping layer 104 works as a retention layer for trapping electrons being injected therein. A second isolating layer 105, made of silicon oxide, is formed to overlay the silicon nitride layer. The silicon oxide layer 105 operates to electrically isolate a conductive gate 102 formed over the second isolating layer 105. The two silicon oxide layers 103, 105 act as isolation dielectric layers.

Numerous advantages of the invention lie in the manner in which the nonvolatile memory cell 10 is programmed, read and erased. In the erase state, electrons are stored in the trapping layer 104, so that the energy level in the channel is normally at a high state. To program the memory cell 10, hot electric holes are injected into the trapping layer 104 from the source 100 or the drain 101 so as to change the energy barrier.

In operating the nonvolatile memory cell according to the invention, it may be desirable to inject the electric holes or electrons into the trapping layer 104 at high speed. It may be further desirable to retain the electrons or electric holes in the trapping layer when the nonvolatile memory cell is not operational. According to a particular embodiment of the invention, the energy barrier of an isolation layer (such as the first isolating layer 103) is 3.2 eV for electrons and 4.9 eV for the electric holes. Such has a generally equal effect on the electrons and electric holes drawn out of the trapping layer 104 and electrons and holes injected into the trapping layer 104 through the first isolating layer 103. It may be further desirable to steadily retain the electrons or electric holes in the trapping layers 104 when the nonvolatile memory cell is not operational. Conversely, when the nonvolatile memory cell is operational, the electrons and electric holes are readily injected into the trapping layer 104. That is, the electrons and electric holes travel through an isolation layer with lower energy barriers so as to speed up the operation of the nonvolatile memory cell.

Fig. 3 is a schematic view illustrating a nonvolatile memory cell implemented according to another embodiment of the invention. In this variant embodiment, a tunnel layer 200 is placed between the channel 107 and the first isolating layer 103. The material of the tunnel layer 200 is particularly selected to provide lower energy barriers to the electrons and electric holes than those of the first isolating layer 103 where the electrons and electric holes are readily injected into the trapping layer and thus the speed in charge storing in the trapping layer 104 is accordingly increased. Since the first isolating layer 103 remains next to the trapping layer 104, the electrons or electric holes in the trapping layer 104 are retained therein as well. According to a particular embodiment of the invention, materials for the tunnel layer 200 can be selected from tantalum oxide or BST (i.e., a compound of barium, strontium, and tantalum).

According to an embodiment, electrons are stored in the trapping layer 104 in an erase state of the memory cell, while hot electric holes are injected in the trapping layer 104 when the memory cell is programmed. The memory cell thereby has a threshold voltage in the erase state which is higher than its threshold voltage in the program state.

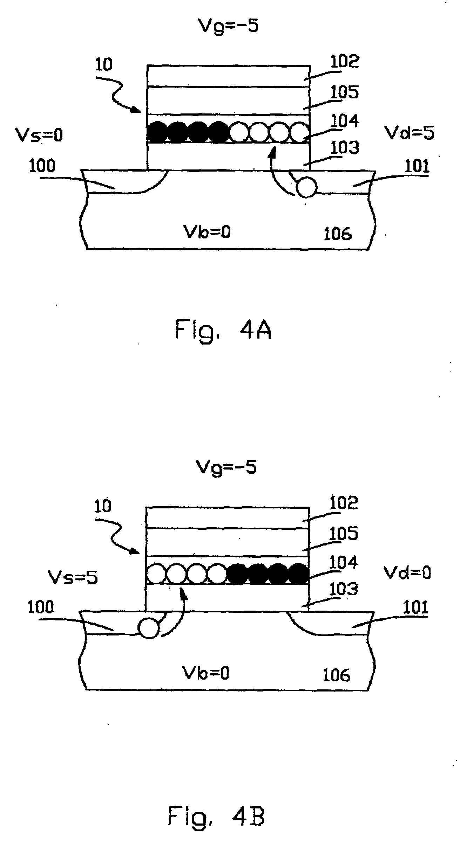

Fig. 4A is a schematic view illustrating an exemplary programming operation of the memory cell according to an embodiment of the invention. The programming operation is performed with respect to the drain bit. To program or write the memory cell, the memory control circuit 20 applies a voltage difference between the drain 101 and the gate 102, while the source 100 is grounded. For example, a voltage of -5 volts (V) is applied to the gate 102 and 5 V is applied to the drain 101. These voltages generate a vertical and lateral electric field along the length of the channel from the drain 101 to the gate 102. This electric field causes electric holes to be drawn off the drain 101 and accelerate towards the source 100. The electric holes gain energy as they move along the length of the channel. When the electric holes gain sufficient energy, they are able to jump over the potential barrier of the silicon oxide layer 103 into the trapping layer 104 where they are trapped. The probability of this occurrence is maximal in the region of the gate next to the drain 101 because it is near the drain 101 where the electric holes gain the most energy. These accelerated electric holes are also called hot holes. Once the hot holes are injected into the nitride layer they become trapped and remain stored therein. The trapped holes cannot spread through the nitride layer due to the low conductivity of the nitride layer and the action of the lateral electric field. Thus, the trapped charge remains in a localized trapping region typically located close to the drain.

Fig. 4B is a schematic view illustrating an exemplary programming operation of a source bit according to an embodiment of the invention. Source bit programming is similar to the drain bit programming, except that the voltages applied to the source 100 and drain 101 are interchanged so as to draw off electric holes from the source 100.

The programming operation as described above can be performed to separately program one bit, i.e. a drain bit or a source bit. Alternatively, more than one bit can be programmed at the same time into the trapping layer 104. In a variant embodiment, a plurality of bits thus can be programmed in parallel under control of the memory control circuit 20, by application of adequate voltages.

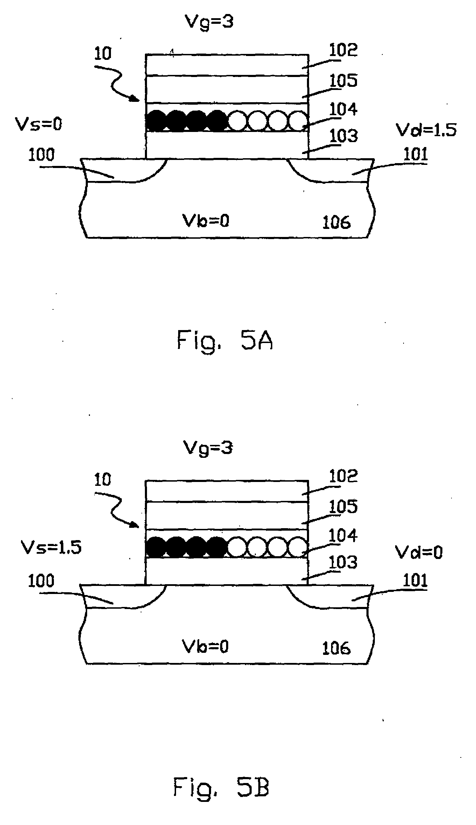

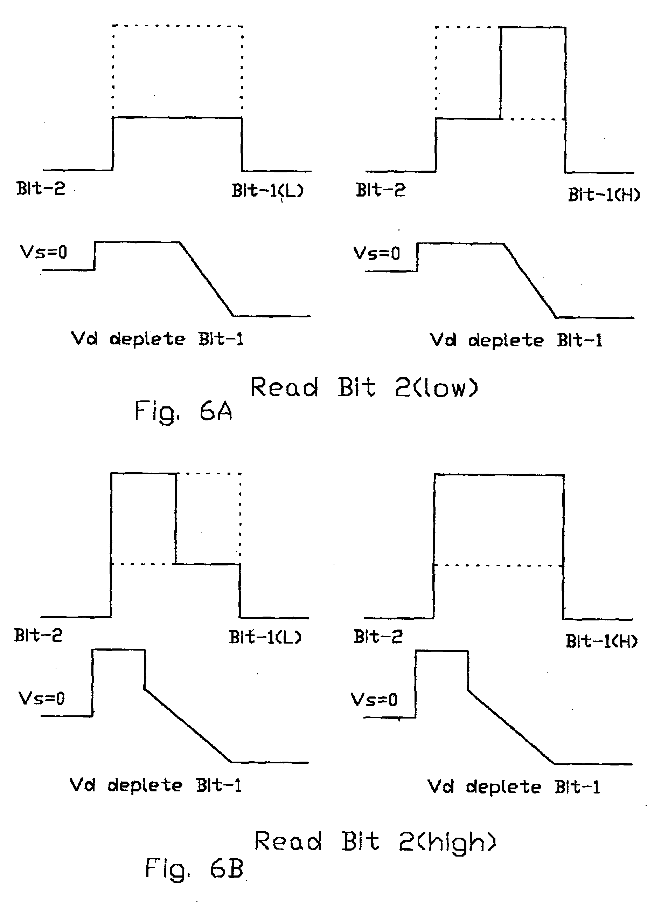

Fig. 5A is a schematic view illustrating an exemplary reading operation of the source bit of the memory cell according to an embodiment of the invention. If it is desired to read a bit stored in the trapping layer near the source 100, the memory control circuit 20 applies a positive voltage to the gate 102 and the drain 101 while the source 100 is grounded. The lower limit for the positive voltage applied to the gate 102 is the voltage at which sufficient inversion is generated in the channel 107 whereby the programmed state can be sensed. The positive voltage applied to the drain 101 reduces the energy barrier and potential across the bit stored near the drain 101, resulting in the channel current. Fig. 6A illustrates the energy barrier distribution and voltage distribution for reading the bit near the source as it is at low state with the bit near the drain in low and high states. Fig. 6B illustrates the energy barrier distribution and voltage distribution for reading the bit near the source as it is at a high state with the bit near the drain in low and high states. Similar to the programming operation, a plurality of bits can be read in parallel by the memory control circuit 20.

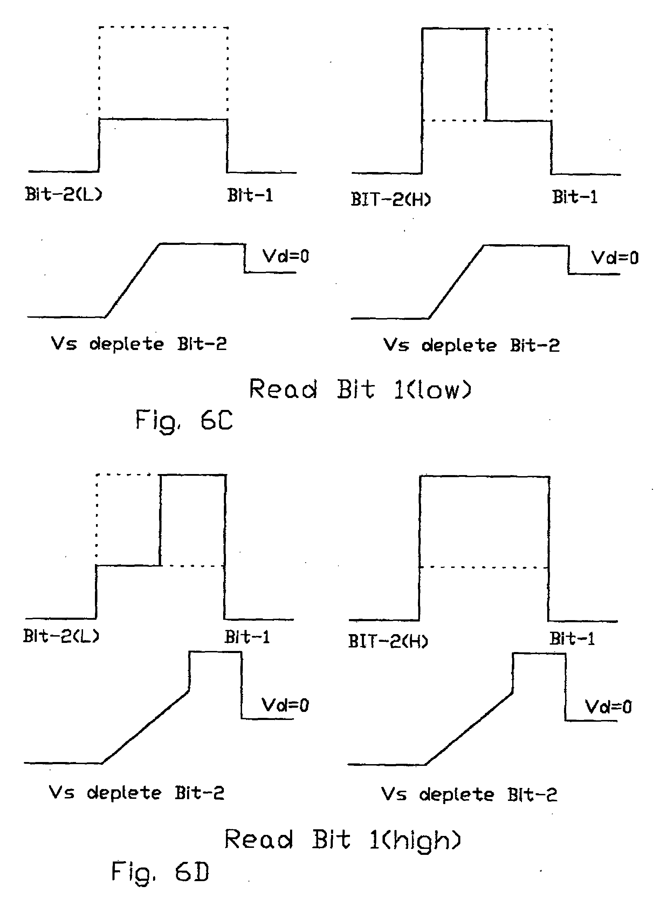

When the device reads the bit in the trapping layer 104 near the drain, as illustrated in Fig. 5B, a positive voltage is applied to the gate 102 and source 100 while the drain 101 is grounded. The lower limit for the positive voltage applied to the gate 102 is the voltage at which sufficient inversion is generated in the channel 107 whereby the programmed state can be sensed. The positive voltage applied to the source 100 reduces the energy barrier and potential across the bit stored near the source 100, resulting in the channel current. Fig. 6C illustrates the energy barrier distribution and voltage distribution for reading the bit near the drain as it is in a low state with the bit near the drain in both low and high states. Fig. 6D illustrates the energy barrier distribution and voltage distribution for reading the bit near the drain as it is in a high state with the bit near the drain in both low and high states.

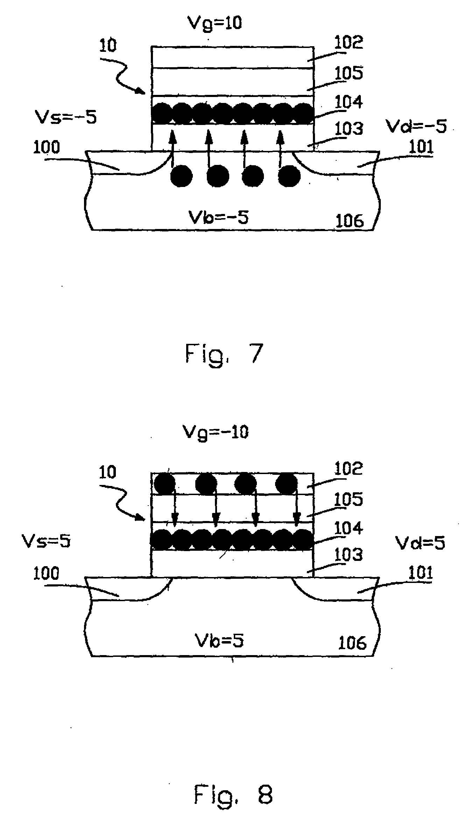

Now reference is made to Fig. 7 to illustrate an exemplary erase operation of the FN (Fowler-Nordheim) injection method according to an embodiment of the invention, where electrons are injected into the trapping layer from the semiconductor substrate. The nonvolatile memory cell according to the invention is erased using uniform electron injection by Fowler-Nordheim tunneling with a positive gate-to-drain/source/substrate bias for substrate injection. In one embodiment, the nonvolatile memory initially may be set to an erase state after its manufacture has been completed or before it is delivered as a final product. This setting can be achieved by a physical method of UV-light irradiation, or by an electric method as described below.

To electrically erase the nonvolatile memory cell, a substrate injection method is utilized. The memory control circuit 20 applies respective voltages to the source 100, drain 101, substrate 106 and the gate 102. For example, a voltage of 10 V is applied to the gate and a voltage of -5V is applied to the drain 101, substrate 106 and source 100. These voltages generate a vertical electric field along the channel region 106 to the gate 102. This electric field causes electrons to be drawn out of the channel region and then tunnel towards the gate. The electrons are able to tunnel through the potential barrier of the silicon oxide layer 103 to be injected into the trapping layer 104 where they are trapped. The tunneling electrons are injected into the nitride layer where they are trapped and remain stored therein.

Furthermore, voltages can be used for an erase operation of the nonvolatile memory cell according to the invention using a negative gate-to-drain/source/substrate bias for substrate injection. Fig. 8 illustrates another exemplary erase operation according the invention where electrons are injected into the trapping layer from the gate using the FN (Fowler-Nordheim) injection method. Voltages are accordingly applied to the source 100, the drain 101, substrate 106 and the gate 102. For example, a voltage of -10 V is applied to the gate and 5V is applied to the drain 101, substrate 106 and source 100. These voltages generate a vertical electric field along the length of the gate 102 to the nitride layer 104. This electric field causes electrons to be drawn off the gate 102 and to tunnel towards the nitride layer 104. The electrons are able to tunnel through the potential barrier of the second isolation layer 105 into the trapping layer 104 where they are trapped. These tunneling electrons are injected into the trapping layer where they are trapped and remain stored therein.

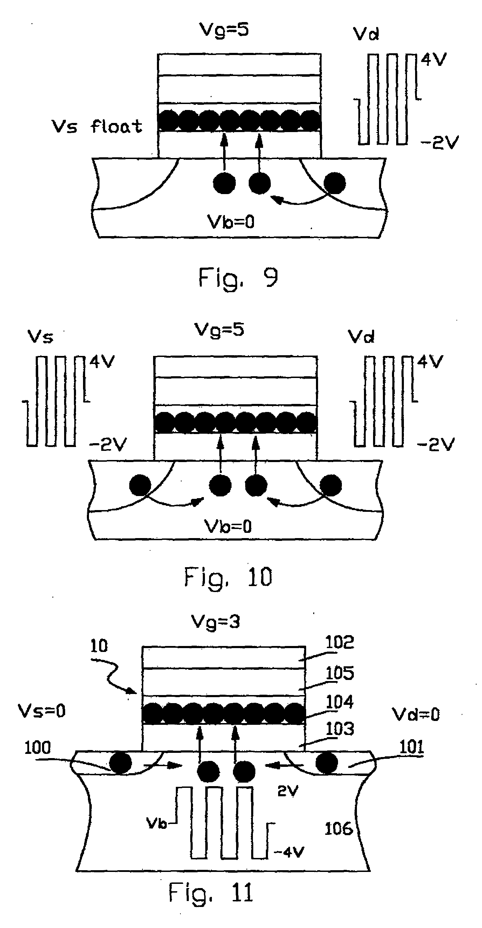

Fig. 9 illustrates an exemplary erase operation for the flash memory cell according the invention using hot electron injection from the drain by applying serial voltage pulses to the substrate. The memory cell is erased by applying serial voltage pulses to the substrate, causing hot electron injection in the memory cell. For this purpose, the memory control circuit 20 applies a positive bias to the gate 102, the source 100 is in a floating state, the substrate is grounded, and serial voltage pulses are input to the drain 101. According to one embodiment, the voltage of the gate is 5 V, where the high voltage of the pulse is 4 V and the lower voltage thereof is -2V. As a negative pulse is input to the drain 101, the electrons in the drain consequently flow out of the drain 101 to the source 100. As a result of applying a positive pulse to the drain 101, the channel between drain 101 and source 100 is cut off. As a charge depletion region is formed in the substrate 106 and an electric field is generated along a path from the drain 101 to the gate 102, the electrons flowing out of the drain 101 travel to the gate 102 and are then trapped in the trapping layer 104 so as to complete the erase operation.

In another embodiment according to the invention, the serial pulses can be input to the source 100 with the drain being floated to achieve generally the same result.

Fig. 10 illustrates yet another exemplary erase operation of the flash memory cell according to the invention using hot electron injection from the source and drain by applying serial voltage pulses to the substrate. According to this variant embodiment, the gate 102 is positively biased and the substrate 106 is grounded. The memory control circuit 20 applies serial voltage pulses to the drain 101 and source 100 synchronously. When negative pulses are applied to the source 100 and drain 101, electrons are drawn off the source 100 and drain 101 and then accelerate towards the channel 107. As the positive pulses are applied to the source 100 and drain 101, a charge depletion region is formed in the substrate 106 and a vertical electric field is generated along the path from the channel 107 to the gate 102. The vertical electric field pumps the electrons out of the source 100 and the drain 101 to pass through the first silicon oxide layer 103 to the trapping layer 104. After filling the trapping layer with electrons for a period of time, the trapping layer 104 is full of electrons so as to erase the original state in the nitride layer.

The erase pulse can be directly applied to the substrate 106 for pumping electrons to the trapping layer. Fig. 11 illustrates yet another exemplary erase operation of the flash memory cell according to an embodiment of the invention using hot electron injection by applying serial voltage pulses to the semiconductor substrate. Electrons are pumped out of the substrate layer 106 and then flow to the trapping layer 104 through the first isolating layer 103. The memory control circuit 20 applies a positive voltage of (e.g., 3 V) to the gate 102, while the source 100 and the drain 101 are grounded. Additionally, serial voltage pulses with a high level of 2 V (for example) and a lower level of -4V (for example) are applied to the substrate 106. As a positive voltage is applied, electrons are drawn out of the source 100 and drain 101. As negative voltage is applied, the electrons out of the source 100 and drain 101 are pumped upwards to the trapping layer 104. After filling the trapping layer with electrons for a period of time, the trapping layer 104 is full of electrons so as to erase the original state in the nitride layer.

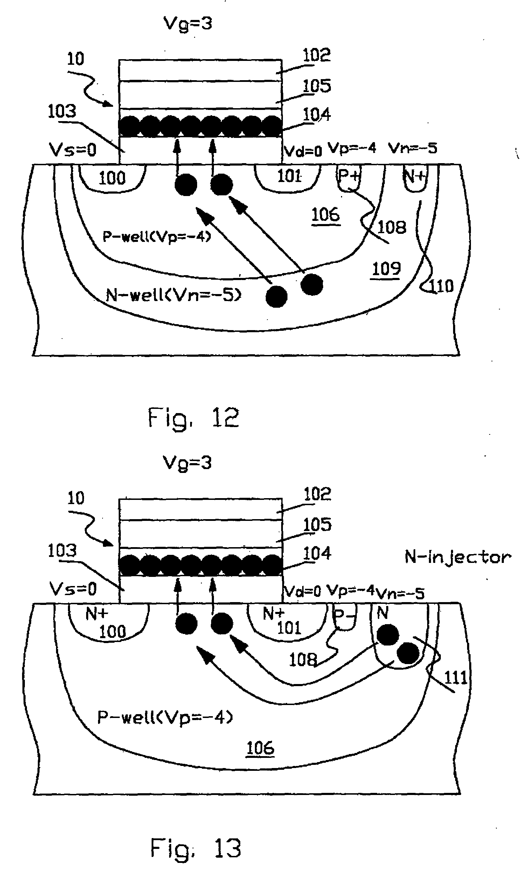

Fig. 12 illustrates another exemplary erase operation of the nonvolatile memory cell according to the invention using electron injection with hot electrons emitted from the N-well. The nonvolatile memory cell according to the invention is erased by hot electron injection, wherein an N-well is provided around the substrate of the nonvolatile memory cell. With a positive gate-to-drain/source bias and a positive P-well-to-N-well bias, electrons are emitted from the N-well, injected into the P-well and trapped in the cell. In this embodiment, the substrate 106 acts as the P-well. An N-well 109 is formed to enclose the substrate 106. A P+ area 108 is formed in the P-well, which is located, but not limited, to the right side of the N+ drain area 101 according to this embodiment. The P+ area 108 is metallized to serve as a connection to an outer component. The N-well 109 enclosing the P-well includes an N+ area 110. The N+ area 110 is located at, but not limited to, one side of the P+ area 108. The N+ area 110 is metallized to serve as a connection contact to an outer component. Under application of a voltage bias between the gate 102 and the N-well 109, electrons are pumped from the N-well to the semiconductor substrate 106, and then flow to the trapping layer 104. As illustrated in Fig. 12, an N-well of a relatively large size can provide a significantly large amount of electrons to be injected to the trapping layer by using a relatively small voltage.

It should be understood that the particular amounts of voltages described herein and above in conjunction with Fig. 12 simply encompass one set of available conditions for performing the erase operation for the nonvolatile memory in accordance with the invention.

Fig. 13 illustrates an additional example of erase operation of the nonvolatile memory cell according to the invention, using electron injection with hot electrons emitted from an N-injector. The nonvolatile memory cell according to the invention is erased by hot electron injection, and an N+ injector is provided in the substrate of the nonvolatile memory cell. Under application of a positive gate-to-drain/source bias and a positive P-well-to-N+ injector bias, electrons are emitted from the N+ injector, and then are injected into the P-well where they are trapped in the memory cell, wherein the substrate 106 acts as the P-well in this embodiment. An N+ injector 111 is formed in the P-well. The N+ injector 111 serves as an electron reservoir, providing electrons to be injected to the trapping layer 104. An P+ area 108 is formed in the P-well. The P+ area 108 is metallized to serve as a connection contact to an outer component. According to this embodiment, the N+ injector 111 and P+ area 108 are located at, but not limited to, the right side of the N+ drain area 101. Under application of a voltage bias between the gate 102 and the N+ injector 110, electrons are pumped from the N+ injector into the P-well and then flow to the trapping layer 104. As illustrated in Fig. 12, an N-well of a relatively large size can provide a significantly large amount of electrons to be injected to the trapping layer by using a relatively small voltage.

For programming the nonvolatile memory in accordance with the invention, the channel is turned off. As a result, no current will flow from the drain 101 to the source 100, or along a reverse path. Thus, the invention advantageously prevents the occurrence of punch-through effects causing large leakage current, high power consumption and low programming efficiency, and the two bits in the memory cell can be well identified. For the erase operation, electrons are stored in the trapping layer where the energy barrier in the channel is increased. The level of the energy barrier in the channel is uniformly distributed in the regions covering the two bits, a bit 1 and a bit 2, in the nonvolatile memory cell. As bit 1 is programmed, the energy barrier on the side of bit 1 is lowered by depleting the trapped electrons or by injecting hot holes, compensating and recombining the amount of carriers in the trapping layer. As bit 2 is programmed, the energy barrier in the side of bit 2 is lowered by depleting the trapped electrons or by injecting hot holes, compensating and recombining the amount of carriers in the trapping layer. When the bits 1 and 2 are programmed, both energy barriers of bit 1 and bit 2 are lowered. Since the voltage from the gate will cut off the channel, no current will punch through the channel. Current paths are only formed between the drain and the trapping layer or between the source and the trapping layer. When the bits 1 and 2 in the trapping layer are very close (e.g., adjacent to one another), there is advantageously no resolution reduction for identifying the two bits.

In above embodiment, the method for programming the trapping layer is by injecting electric holes to the layer. As electric holes are injected to the trapping layer, it has the effect of reducing the net charges in the trapping layer of the memory cell. Drawing electrons out of the trapping layers also achieve substantially the same result. Thus, the method of drawing electrons out of the trapping layer to achieve the object of programming the nonvolatile memory cells is also within the scope of the present invention.

Realizations in accordance with the present invention have been described in the context of particular embodiments. These embodiments are meant to be illustrative and not limiting. Many variations, modifications, additions, and improvements are possible. Accordingly, plural instances may be provided for components described herein as a single instance. Additionally, structures and functionality presented as discrete components in the exemplary configurations may be implemented as a combined structure or component. These and other variations, modifications, additions, and improvements may fall within the scope of the invention as defined in the claims that follow.

## Claims

1. A nonvolatile memory, comprising:
at least one memory cell comprising:
a semiconductor substrate including a source and a drain spaced from the source;
a first isolating layer overlying at least the portion of the substrate between the source and the drain;
a nonconducting charge trapping layer overlaying the first isolating layer;
a second isolating layer overlaying the nonconducting charge trapping layer;
a gate overlaying the second isolating layer; and
a memory control circuit coupled with the memory cell, wherein the memory control circuit is configured to control the operation of the memory cell;
wherein the nonconducting charge trapping layer of the memory cell has a net negative charge in an erase state of the memory cell.

2. The nonvolatile memory of claim 1, wherein the nonconducting charge trapping layer is made of nitride or Al₂O₃ or HFO₂.

3. The nonvolatile memory of claim 1, wherein the memory cell further comprising a tunnel layer between the substrate and the first isolating layer, the tunnel layer being configured to have an electron or electric hole energy barrier lower than that of the first isolating layer.

4. The nonvolatile memory of claim 3, wherein the tunnel layer is made of titanium oxide or a barium-strontium-tantalum compound.

5. The nonvolatile memory of claim 1, wherein the memory control circuit is configured to apply a first set of voltages to program the memory cell, the first set of voltages causing the movement of electric holes into the nonconducting charge trapping layer of the memory cell.

6. The nonvolatile memory of claim 1, wherein the memory control circuit is configured to apply a second set of voltages to erase the memory cell, the second set of voltages causing the movement of electrons into the nonconducting charge trapping layer of the memory cell.

7. The nonvolatile memory of claim 1, wherein the memory cell further comprising an N+ injector in the semiconductor substrate.

8. The nonvolatile memory of claim 7, wherein the memory control circuit is configured to erase the memory cell by performing a process comprising:
grounding the drain and the source; and
applying voltages respectively to the gate, the semiconductor substrate and the N+ injector.

9. The nonvolatile memory of claim 6, wherein the memory control circuit is configured to erase the memory cell by performing a process comprising:
applying a voltage to the gate;
applying a voltage to one of the drain or the source;
leaving the other one of the drain or the source in a floating state; and
grounding the semiconductor substrate.

10. The nonvolatile memory of claim 6, wherein the memory control circuit is configured to erase the memory cell by performing a process comprising:
applying a voltage to the gate;
applying a voltage to the source and the drain synchronously; and
grounding the semiconductor substrate.

11. The nonvolatile memory of claim 6, wherein the memory control circuit is configured to erase the memory cell by performing a process comprising:
applying a voltage to the gate;
grounding the source and the drain; and
applying a voltage to the semiconductor substrate.

12. The nonvolatile memory of claim 6, wherein the memory control circuit is configured to erase the memory cell by performing a process comprising:
applying a positive voltage to the gate;
applying a negative voltage to the semiconductor substrate;

13. The nonvolatile memory of claim 6, wherein the memory control circuit is configured to erase the memory cell by performing a process comprising:
applying a negative voltage to the gate; and
applying a positive voltage to the semiconductor substrate so as to move electrons into the trapping layer.

14. A nonvolatile memory cell comprising:
a semiconductor substrate including a source and a drain spaced from the source, ;
a first isolating layer overlying at least the portion of the substrate between the source and the drain;
a nonconducting charge trapping layer overlaying the first isolating layer for receiving and retaining electrons in at least one storge region;
a second isolating layer overlaying the nonconducting charge trapping layer;
a gate overlaying the second isolating layer; and
wherein electrons are moved into said storage region in an erase state so as to cause the memory cell to have a first threshold voltage, and wherein the memory cell has a second threshold voltage in a program state which is lower than the first threshold voltage.

15. A method for manufacturing a nonvolatile memory cell, comprising the steps of:
providing a semiconductor substrate;
forming a source and a drain spaced from said source in the substrate;
forming a first isolating layer overlying at least the portion of the substrate between the source and the drain;
forming a nonconducting charge trapping layer overlaying said first isolating layer for retaining electrons in at least one storage region;
forming a second isolating layer overlaying said nonconducting charge trapping layer;
forming a gate overlaying said second isolating layer;
wherein electrons are moved into said storage region in an erase state so as to cause the memory cell to have a first threshold voltage, and wherein the memory cell has a second threshold voltage in a program state which is lower than the first threshold voltage.

16. The method of claim 15, wherein said nonconducting charge trapping layer is made of nitride, AlO₃, or HFO₂.

17. The method of claim 15, further comprising a step of forming a tunnel layer overlying and covering said substrate, said tunnel layer including energy barriers for electrons and electric holes which are lower than those of said first isolating layer.

18. The method of claim 17, wherein said tunnel layer is made of titanium oxide or BST (barium, strontium and tantalum compound).

19. The method of claim 15, wherein the memory cell is changed into the program state by the steps of:
applying a first voltage between said gate and one of said source or drain to cut off a current flow from said one of the source or drain to said gate; and
applying a second voltage between said gate and the other one of said source or drain to form an electric field which causes a current to flow along a path from said other one of said source or drain to said trapping layer.

20. The method of claim 15, wherein the memory cell is programmed into a program state by the steps of:
applying a first voltage between said gate and one of said source or drain to form an electric field which causes a first current to flow along a path from said one of said source or drain to a first storage region in said trapping layer; and
applying a second voltage between said gate and the other one of said source or drain to form a second electric field which causes a second current to flow along a second path from the other one of said source or drain to a second storage region in said trapping layer.
